# EUROPEAN PATENT APPLICATION

(11) **EP 0 698 927 A2**
(43) Date of publication of application: **28.02.1996**
(21) Application number: 95112925.3
(22) Date of filing: 17.08.1995
(51) Int. Cl.: H01L 29/92, H01L 27/08

(54) **Unit capacitor**

(30) Priority: 25.08.1994 JP 200968/94
(71) Applicant: MOTOROLA, INC., Schaumburg, IL 60196 (US)
(72) Inventor: Suzuki, Masami, Ann Arbor, MI 48104 (US); Sekine, Satoshi, Sendai-shi, Miyagi-ken 981-32 (JP); Asato, Mamoru, Tokyo 176 (JP)
(74) Representative: Hudson, Peter David

(57) **Abstract**

The invention provides a new structure of a unit capacitor that enables the reduction in size of a capacitor array.

A unit capacitor comprising a first electrode layer (3) attached onto a surface region of a semiconductor substrate; a second electrode layer (4) extending in parallel with the first electrode layer (3); and electric line of force absorption means (13) for absorbing an electric line of force drawn from an edge of the second electrode layer (4).

## Description

### FIELD OF THE INVENTION

The present invention relates to a unit capacitor formed onto a semiconductor substrate, and more specifically to a unit of a capacitor array within an A/D converter or a D/A converter.

### BACKGROUND OF THE INVENTION

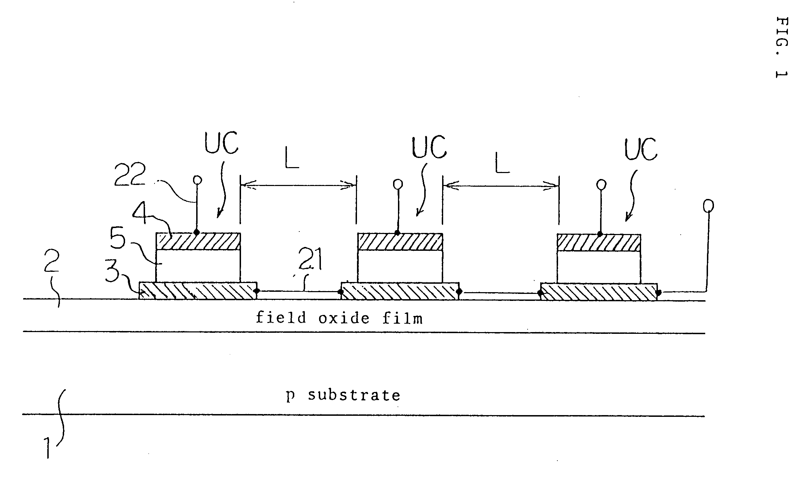

Fig. 1 is an illustration showing a cross-section of such a capacitor array.

In Fig. 1, a field oxide film 2 is attached onto a p-type semiconductor substrate 1. A plurality of unit capacitors, UC, are arranged in an array on the field oxide film 2.

Each of the unit capacitors UC comprises a polysilicon layer 3 attached onto the field oxide film 2, a polysilicon layer 4, and an insulating film 5 sandwiched between the polysilicon layers 3 and 4. Further, electrode lines 21 and 22 are deposited onto the polysilicon layers 3 and 4, respectively. These polysilicon layers 3 and 4 form first and second electrodes of the capacitor, respectively.

Each of the unit capacitors UC arranged in an array on the field oxide film 2 draws electric lines of force during its operation. Especially, the lateral electric line of force drawn from an edge of the polysilicon layer 4 affects the adjacent unit capacitor UC, causing variations in capacitance. Thus, to prevent variations in capacitance due to the effects of the electric line of force emitted from adjacent unit capacitors UC, they were spaced a predetermined distance, L, apart from each other.

As described above, to form a capacitor array accurately and uniformly on the semiconductor substrate, it is necessary to separate adjacent unit capacitors UC apart from each other by a predetermined distance L, which poses a problem in terms of their high-density fabrication.

Accordingly, it is an object of the present invention to provide a unit capacitor that enables high-density fabrication of an accurate and uniform capacitor array.

In accordance with the present invention, a unit capacitor comprises a first electrode layer attached onto a semiconductor substrate; a second electrode layer extending in parallel with said first electrode layer; and electric line of force absorption means for absorbing an electric line of force drawn from an edge of said second electrode layer.

### SUMMARY OF THE INVENTION

In accordance with the present invention, the unit capacitor comprising a first electrode layer attached onto a semiconductor substrate and a second electrode layer extending in parallel with the first electrode layer reduces external leakage of an electric line of force by providing electric line of force absorption means for absorbing an electric line of force drawn from an edge of the second electrode layer.

### BRIEF DESCRIPTION OF THE DRAWINGS

Fig. 1 is an illustration showing a cross-sectional view of a capacitor array.

Fig. 2 is an illustration showing a cross-sectional view of a unit capacitor according to the present invention.

Fig. 3 is an illustration showing a plan view of the unit capacitor according to the present invention.

Fig. 4 is an illustration showing how electric lines of force are absorbed in the unit capacitor of the present invention.

### DETAILED DESCRIPTION OF THE PREFERRED EMBODIMENT

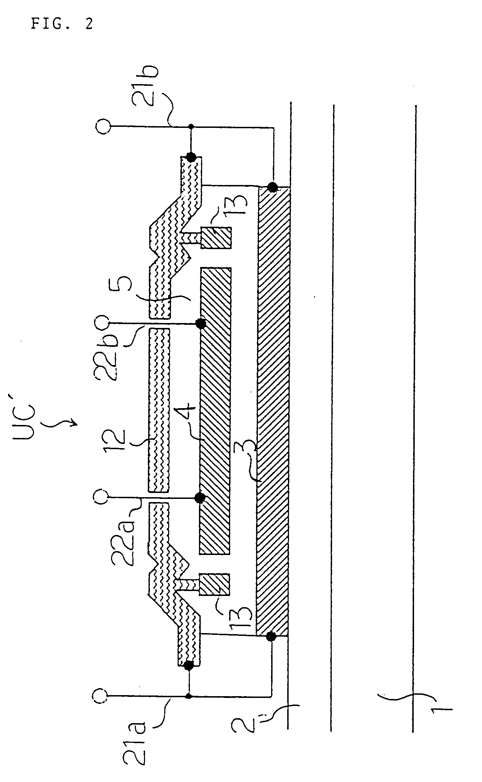

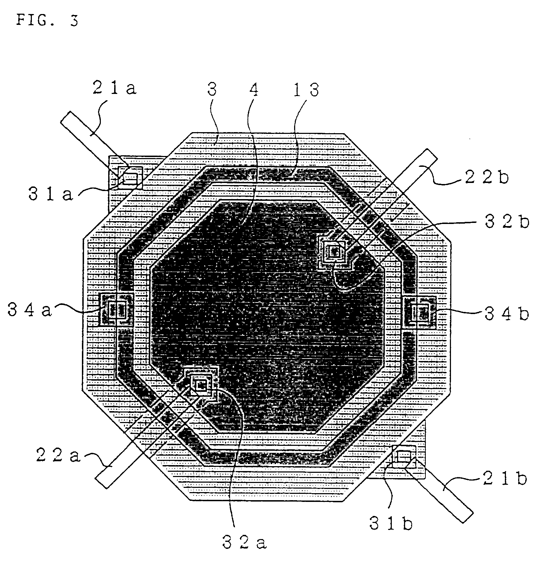

Figs. 2 and 3 are illustrations showing the arrangement of a unit capacitor UC' according to the present invention.

Fig. 2 is an illustration showing a cross-sectional view of the unit capacitor UC', and Fig. 3 is an illustration showing a plan view thereof. It will be appreciated that Fig. 3 is a plan view taken above the unit capacitor UC' under conditions where a metal layer 12 (described later) is removed from the unit capacitor UC' shown in Fig. 2.

In Fig. 2, a field oxide film 2 is attached onto a p-type semiconductor substrate 1. The unit capacitor UC' comprises a polysilicon layer 3 attached onto the field oxide film 2, a polysilicon layer 4, a metal layer 12, a polysilicon ring 13, and an insulating layer 5 formed with an insulative material filled between these polysilicon layer 3, polysilicon layer 4, metal layer 12 and polysilicon ring 13. The polysilicon layer 4 extends in parallel with the polysilicon layer 3, so that these polysilicon layers 3 and 4 form first and second electrodes of the unit capacitor UC', respectively.

As shown in Fig. 3, the polysilicon layers 3 and 4 define their octagonal regions. The polysilicon ring 13 is formed surrounding each edge of the octagonal polysilicon layer 4. Further, the polysilicon ring 13 is connected to the metal layer 12 via contacts 34a and 34b. It will be appreciated that the metal layer 12 (not shown) defines its region so as to cover the entire region of at least the polysilicon layer 4.

To the polysilicon layer 3 are connected metal wires 21a and 21b via contacts 31a and 31b, respectively. Further, the metal layer 12 is connected to the metal wires 21a and 21b via the contacts 31a and 31b. More specifically, the polysilicon layer 3 and polysilicon ring 13 are electrically connected by the metal wires 21a and 21b. A first electrode line for the unit capacitor UC' is formed by these metal wires 21a and 21b. Additionally, to the polysilicon layer 4 are connected metal wires 22a and 22b via contacts 32a and 32b, respectively. A second electrode line for the unit capacitor UC' is formed by these metal wires 22a and 22b.

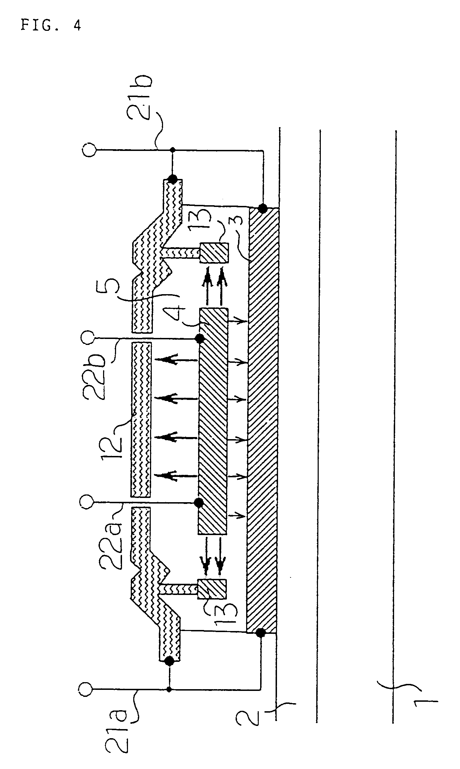

Fig. 4 shows how electric lines of force are absorbed in the unit capacitor UC' so configured.

As shown in Fig. 4, during operation of the unit capacitor UC', the electric lines of force indicated by the arrow in the figure are drawn from the surface of the polysilicon layer 4. The electric line of force drawn from the bottom of the polysilicon layer 4 is absorbed by the polysilicon layer 3. Additionally, the electric line of force drawn from the top of the polysilicon layer 4 is absorbed by the metal layer 12.

In the unit capacitor UC' of the present invention, by providing the polysilicon ring 13 as an electric line of force absorption means, an electric line of force drawn from an edge of the polysilicon layer 4 is also absorbed.

Thus, because the electric lines of force drawn during operation of the unit capacitor UC' are absorbed by the metal layer 12 and polysilicon ring 13, the amount of these electric lines of force leaked externally is reduced.

In the above embodiment, the polysilicon layers 3 and 4 are used as first and second electrodes of the unit capacitor UC', respectively; however, these first and second electrodes may not necessarily be polysilicon, but may be implemented by using a metal layer of a certain metal, for example.

Additionally, in the above embodiment, the planar regions of the polysilicon layers 3 and 4 and polysilicon ring 13 are octagonal; however, they are not limited thereto, but may be rectangular or circular. In other words, it is sufficient that the polysilicon ring 13 is formed so as to surround each edge of the polysilicon layer 4.

Furthermore, in the above embodiment, the polysilicon ring 13 is disposed so as to surround each edge of the polysilicon layer 4; however, this ring may not necessarily be polysilicon, but may be implemented by using a metal ring, for example. That is, a conductive ring may be disposed to surround in an annular manner near the edge of the electrode so that an electric line of force drawn from the edge of the electrode of the unit capacitor UC' is absorbed.

As is clear from the above description, a unit capacitor according to the present invention comprises a first electrode layer attached onto a semiconductor substrate; a second electrode layer extending in parallel with the first electrode layer; and electric line of force absorption means for absorbing an electric line of force drawn from an edge of the second electrode layer, whereby external leakage of such an electric line of force is reduced.

Thus, during operation of the unit capacitor, external leakage of the electric line of force drawn from the edge of the electrode can be reduced.

Additionally, by using a conductive ring formed to surround in an annular manner near the edge of the second electrode, electric lines of force drawn from all the edges of the second electrode layer are absorbed, thereby allowing for reduction in external leakage of such electric lines of force.

Thus, according to the unit capacitor of the present invention, when a capacitor array with a plurality of unit capacitors arranged in an array is formed on a semiconductor substrate, variations in capacitance will not be caused by electric lines of force even if the distance between adjacent unit capacitors is made relatively small, so that accurate, high-density fabrication can be implemented.

## Claims

1. A unit capacitor which comprises:
a first electrode layer(3) attached onto a surface region(2) of a semiconductor substrate(1);
a second electrode layer(4) extending in parallel with said first electrode layer(3); and
electric line of force absorption means(13) for absorbing an electric line of force drawn from an edge of said second electrode layer(4).

2. A unit capacitor according to claim 1, wherein said electric line of force absorption means is a conductive ring(13) which surrounds in an annular manner near the edge of said second electrode layer(4).

3. A unit capacitor according to claim 2, wherein said conductive ring(13) comprises a polysilicon.

4. A unit capacitor according to claim 2, wherein said conductive ring(13) is electrically connected to said first electrode layer(3).

5. A unit capacitor according to claim 2, wherein said first and second electrode layers(3, 4) are electrode layers formed of a circular or polygonal planar area, and wherein said conductive ring(13) is formed by surrounding said second electrode layer(4) in a circular or polygonal ring shape.
